# FASCICULE DE BREVET EUROPEEN

(11) **EP 3 858 119 B1**
(45) Date de publication et mention de la délivrance du brevet: **25.10.2023**
(21) Numéro de dépôt: 19783590.3
(22) Date de dépôt: 04.09.2019
(51) Int. Cl.: H05K 5/02, H05K 7/14

(54) **ENSEMBLE COMPRENANT UN MODULE D'ALIMENTATION ÉLECTRIQUE ET UN DISPOSITIF DE PROTECTION DUDIT MODULE, BLOC DE CLIMATISATION ÉQUIPÉ D'UN TEL ENSEMBLE**
ANORDNUNG MIT EINEM ELEKTRISCHEN VERSORGUNGSMODUL UND EINER SCHUTZVORRICHTUNG FÜR DAS MODUL, KLIMAANLAGE MIT EINER SOLCHEN ANORDNUNG
ASSEMBLY COMPRISING AN ELECTRICAL SUPPLY MODULE AND A PROTECTION DEVICE FOR SAID MODULE, AIR CONDITIONING UNIT EQUIPPED WITH SUCH AN ASSEMBLY

(30) Priorité: 24.09.2018 FR 1858620
(43) Date de publication de la demande: 04.08.2021
(73) Titulaire: VALEO SYSTEMES THERMIQUES, 78320 Le Mesnil Saint-Denis (FR)
(72) Inventeur: COLINET, Sébastien, 78322 LE MESNIL SAINT-DENIS CEDEX (FR); KARAASLAN, Serif, 78322 LE MESNIL SAINT-DENIS CEDEX (FR)
(74) Mandataire: Valeo Systèmes Thermiques
(86) Numéro de dépôt international: PCT/FR2019/052040
(87) Numéro de publication internationale: WO 2020/065160

(56) Documents cités:
- US-A1- 2011 304 248
- US-A1- 2015 334 854
- US-A1- 2015 340 933

## Description

### Domaine de l'invention

L'invention concerne un ensemble comprenant un module d'alimentation électrique et un dispositif de protection dudit module. L'invention concerne également un bloc de climatisation comprenant un tel ensemble, notamment pour véhicules automobiles.

### Etat de la technique

Les boîtiers de climatisation de véhicules automobiles disposent classiquement d'un emplacement servant à accueillir un corps de chauffe dans lequel est installée une pluralité d'éléments chauffant alimentés en courant depuis un module d'alimentation. Le module d'alimentation est situé en dehors du bloc de climatisation. Il comprend généralement une carte de circuit imprimé. De manière classique, la carte de circuit imprimé comporte un ou plusieurs connecteurs à des circuits externes. Ces connecteurs sont localisés à la surface du module d'alimentation de manière à pouvoir être aisément raccordés à des câbles.

De nombreux modules d'alimentation présentent ainsi des zones partiellement étanches, voire même non étanches. Par exemple, il peut s'agir d'une zone de raccordement des connecteurs aux câbles ou même de zones d'assemblage de pièces formant un boîtier desdits modules d'alimentation.

Or, les exigences standards de protection des équipements électriques des véhicules automobiles imposent que ces équipements soient efficacement protégés contre la pénétration de poussières et d'eau. Afin de satisfaire aux exigences fixées, les équipements électriques doivent donc être soumis à un test, durant lequel ils sont inclinés de +/- 15° et exposés à un écoulement de liquide assimilable à une forte pluie. Pour valider ce test, aucune trace d'eau ne doit être détectée à l'intérieur desdits équipements électriques. À la demande des constructeurs de véhicules automobiles, les équipementiers doivent réaliser des modules d'alimentation respectant ces exigences. US 2015/340933 A1 montre un assemblage de compresseur électrique avec un couvercle qui protège les circuits à l'intérieur d'un boîtier.

C'est dans ce contexte que s'inscrit l'invention qui propose un ensemble d'un module d'alimentation électrique et d'un dispositif de protection dudit module, ledit ensemble étant destiné à équiper un bloc de climatisation, notamment pour véhicule automobile, ledit module d'alimentation comprenant un boîtier muni de zones permettant une pénétration de liquide à l'intérieur du boîtier, le dispositif de protection s'étendant au moins en partie en vis-à-vis desdites zones de manière à entraîner un écoulement du liquide au-delà desdites zones, en fonction de l'orientation dudit module d'alimentation. L'invention est définie exclusivement dans la revendication 1. Des réalisations préférées sont illustrées dans les revendications dépendantes.

On dispose de la sorte d'un dispositif de protection qui permet de protéger le module d'alimentation de tout écoulement liquide que ce soit par éclaboussure ou ruissellement du liquide, et ceci pas seulement à la verticale mais également, dans une certaine limite, quel que soit l'angle d'inclinaison.

Selon d'autres caractéristiques de l'invention, qui pourront être prises ensemble ou séparément :
- le dispositif de protection comprend une plaque déflectrice comprenant une première concavité et/ou une deuxième concavité ;
- le module d'alimentation électrique comprend une première zone comportant une ligne de jonction entre deux pièces du boîtier ;
- le module d'alimentation électrique comprend une deuxième zone de branchement à des connecteurs externes ;
- ladite plaque déflectrice s'étend en vis-à-vis desdites première et/ou deuxième zones ;
- la plaque déflectrice comprend une portion de sommet, ainsi qu'une première portion inclinée et/ou une deuxième portion inclinée ;
- les portions inclinées et/ou la portion de sommet sont planes ;
- lesdites portions sont reliées à ladite portion de sommet par des coudes ;
- l'une au moins des portions inclinées comprend un organe de retenue s'étendant à partir de ladite deuxième portion inclinée pour favoriser l'écoulement du liquide dans une direction donnée ;
- la plaque déflectrice comprend un flanc d'accostage au bloc de climatisation ;
- la plaque déflectrice comprend un flanc incliné ;
- lesdits flancs d'accostage et incliné sont situés au niveau de côtés opposés de la portion de sommet ;
- la plaque comprend des cloisons de renfort s'étendant à partir de la portion de sommet et/ou desdites première et/ou deuxième portions inclinées ;
- le dispositif de protection comprend un moyen de fixation au bloc de climatisation ;
- la plaque déflectrice comprend un orifice de passage pour un ou plusieurs câbles électriques d'alimentation du module d'alimentation ;
- le module d'alimentation comprend une carte de circuit imprimé, ladite carte étant revêtue d'une couche faite d'un matériau hydrophobe.

L'invention concerne en outre un bloc de climatisation pour véhicule automobile équipé d'un ensemble tel que décrit précédemment.

Avantageusement, ledit bloc comprend un dispositif de chauffage électrique muni dudit module d'alimentation.

### Présentation des figures

D'autres objets, caractéristiques et avantages de l'invention apparaîtront plus clairement dans la description qui suit, faite en référence aux figures annexées, dans lesquelles :
- la figure 1 illustre de manière schématique, en vue latérale, un module d'alimentation électrique selon l'invention monté sur un bloc de climatisation, illustré partiellement ;
- la figure 2 illustre de manière schématique, en perspective, un dispositif de protection du module d'alimentation de la figure 1, ledit dispositif et ledit module formant un ensemble selon l'invention ;
- la figure 3 illustre de manière schématique, en vue latérale, une variante d'un ensemble d'un module d'alimentation électrique et d'un dispositif de protection du module d'alimentation, selon l'invention.

### Description détaillée

L'invention concerne un ensemble d'un module d'alimentation électrique 2 et d'un dispositif de protection 1 dudit module, ledit ensemble étant destiné à équiper un bloc de climatisation 3, notamment pour véhicule automobile.

Le bloc de climatisation 3 est destiné à être situé sous le tableau de bord du véhicule. Il permet la circulation d'un flux d'air destiné à être refroidi et/ou réchauffé avant d'être envoyé vers l'habitacle du véhicule. Un logement est prévu au sein dudit bloc de climatisation 3 pour accueillir un radiateur de chauffage. Ce radiateur de chauffage comporte un corps de chauffe non-visible et le module d'alimentation 2.

Le corps de chauffe comporte des éléments chauffants aptes à chauffer le flux d'air envoyé dans l'habitacle du véhicule automobile après avoir traversé le corps de chauffe et reliés électriquement au module d'alimentation 2 au moyen d'électrodes. Le corps de chauffe est ici inséré dans le bloc de climatisation 3 par une de ses parois latérales à travers une lumière prévue sur celle-ci.

Le module d'alimentation 2 sert à alimenter en courant les éléments chauffants via les électrodes. Pour assurer le contrôle du courant, il comprend une carte de circuit imprimé permettant de supporter et connecter électriquement un ensemble de composants électroniques entre eux.

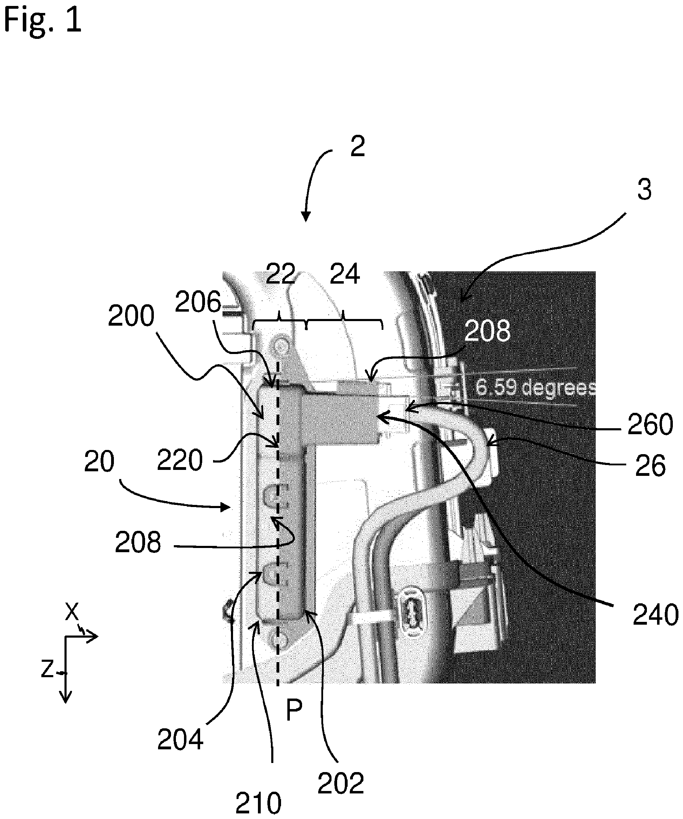

Comme illustré à la figure 1, lorsque le radiateur de chauffage est positionné de manière appropriée au sein du bloc de climatisation 3, le module d'alimentation 2 reste en dehors dudit bloc de climatisation 3.

Le module d'alimentation 2 comprend un boîtier 20 renfermant ici la carte de circuit imprimée et l'ensemble de composants électroniques servant à alimenter et contrôler le corps de chauffe. Le boîtier 20 comprend des zones 22, 24 permettant potentiellement une pénétration de liquide non-désirée à l'intérieur dudit boîtier 20. Autrement dit, lesdites zones ne sont partiellement pas étanches, voire ne sont pas étanches.

Une première zone 22 du boîtier 20 comporte une ligne de jonction 220 entre deux pièces 200 et 202 d'assemblage dudit boîtier. Ladite ligne de jonction 220 s'étend sur tout le pourtour du boîtier 20. Plus précisément, ladite ligne de jonction 220 s'étend sur une face supérieure 206, une face latérale 208 et une face inférieure 210 du boîtier 20 en passant ici par un plan médian P du module d'alimentation.

Aux fins de la fermeture du boîtier 20 et du serrage des pièces 200 et 202 entre elles, des moyens de fermeture 204 peuvent être prévus au niveau de la ligne de jonction 220. À cet égard, les moyens de fermeture 204 consistent, par exemple, en deux organes. Un premier organe est en saillie de l'une au moins desdites pièces 200, 202, tandis qu'un deuxième organe est relié par une charnière à l'autre desdites pièces 200, 202, le deuxième organe présentant un orifice de forme complémentaire à la forme du premier organe.

Pour autant, lesdits moyens de fermeture 204 ne permettent pas de garantir l'étanchéité entre les deux pièces le long de la ligne de jonction 220.

En outre, le boîtier 20 comprend une deuxième zone 24 de branchement du module d'alimentation 2 à un ou des connecteurs 260 à des circuits externes munis de câbles 26. La deuxième zone 24 de branchement comprend d'une interface de branchement 240 aux connecteurs 260. Ladite interface de branchement 240 est située, notamment, à une extrémité distale de ladite deuxième zone 24, opposée à la dite première zone 22. L'interface de branchement 240 peut ne pas être étanche.

Ainsi, le module d'alimentation 2 comprend donc, dans la première zone 22 et la deuxième zone 24, des zones dans lesquels un liquide arrivant sur le boîtier 20 est susceptible de pouvoir pénétrer et avoir accès à la carte de circuit imprimé et/ou aux composants électriques se trouvant à l'intérieur dudit module.

L'ensemble selon l'invention peut adopter différentes configurations.

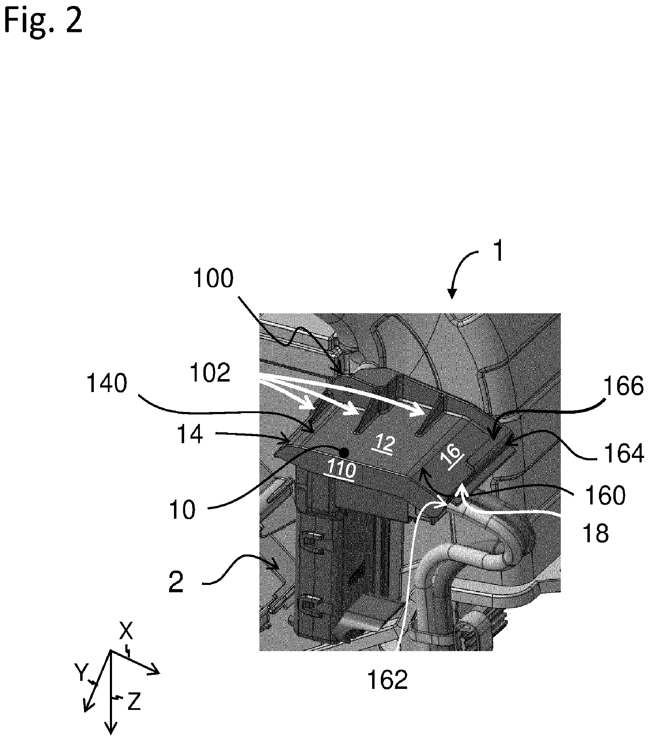

Dans une première configuration, illustrée à la figure 2, la deuxième zone 24 du module d'alimentation 2 s'étend de manière sensiblement perpendiculaire à la première zone 22 en formant une excroissance issue d'une grande face du boîtier. Un léger décalage angulaire de quelques degrés est également possible. Toujours selon la première configuration, le dispositif de protection 1 est situé sensiblement au-dessus de la face supérieure 206 du boîtier 20, en utilisation.

On peut prévoir un autre agencement respectif de la deuxième zone 24 par rapport à la première zone 22, pour faciliter le branchement des câbles 26 électriques d'alimentation du module d'alimentation 2 aux connecteurs à des circuits externes.

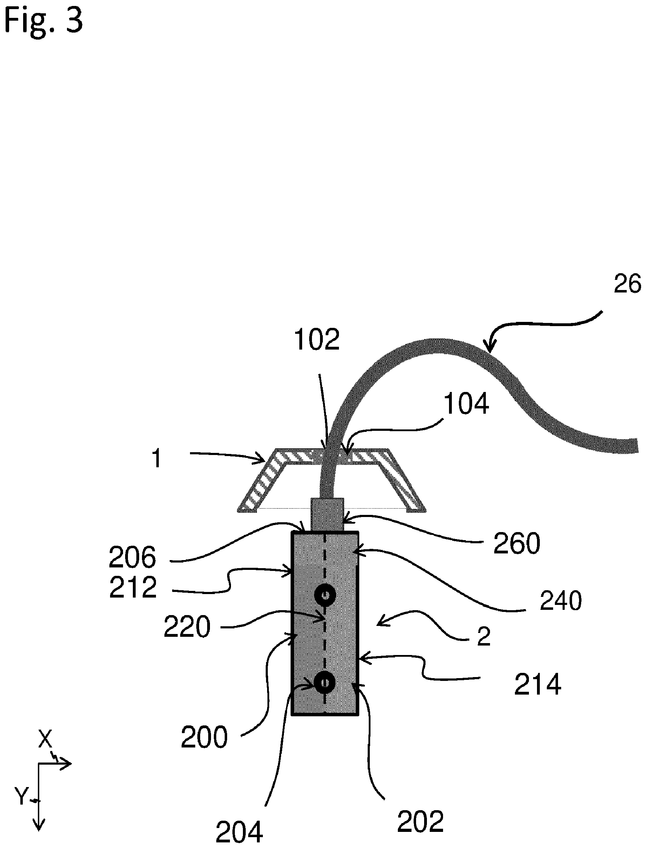

Dans une deuxième configuration, illustrée à la figure 3, la deuxième zone 24 s'étend ainsi à partir de la face supérieure 206, dans le prolongement de la première zone 22. Dans cette configuration également, le dispositif de protection 1 est situé sensiblement au-dessus de la face supérieure 206, en utilisation.

Cela étant, quelle que soit la configuration, le dispositif de protection 1 s'étend au moins en partie en vis-à-vis desdites zones 22, 24 de manière à entraîner un écoulement du liquide au-delà desdites, en fonction de l'orientation dudit module d'alimentation de sorte que toute pénétration de liquide à l'intérieur du boîtier 20 soit évitée, et, que la carte de circuit imprimé et les composants électriques soient protégés.

Le dispositif de protection 1 comprend une plaque déflectrice 10, ladite plaque comprenant une première et/ou une deuxième concavité. La plaque déflectrice 10 s'étend au moins en partie en vis-à-vis desdites première et deuxième zones 22, 24.

Préférentiellement, pour former ladite première concavité, la plaque déflectrice 10 comprend, une portion de sommet 12, une première portion inclinée 14 et une deuxième portion inclinée 16. Les première et deuxième portions inclinées 14, 16 sont situées de part et d'autre de la portion de sommet 12, et, reliées à ladite portion de sommet 12 au moyen de coudes 140, 160.

Un tel agencement permet, d'une part, d'entraîner l'écoulement du liquide au-delà desdites première et deuxième zones 22, 24, et d'autre part, d'éviter que du liquide ne s'accumule sur la portion de sommet 12, et ce y compris lorsque le bloc de climatisation 3 est soumis à une inclinaison, notamment de +/- 15° dans un premier plan, parallèle à ladite face latérale 208.

Dans la configuration de la figure 2, la première portion inclinée 14 se situe au moins en partie en vis-à-vis de la première zone 22, et, s'étend au-delà d'une bordure latérale de ladite première zone. La deuxième portion inclinée 16 se situe, quant à elle, au moins en partie en vis-à-vis de l'interface de branchement 240 aux connecteurs, et, s'étend au-delà de cette interface 240 en vis-à-vis des câbles 26.

Préférentiellement, la portion de sommet 12 et les portions inclinées 14, 16 peuvent être planes. Alternativement, lesdites portions de sommet 12 et inclinées 14 et 16 peuvent être courbées, ou adopter tout autre configuration, dès lors qu'elles permettent d'entraîner l'écoulement liquide au-delà desdites première et deuxième zones 22, 24.

Avantageusement, si l'excroissance formant la deuxième zone 24 est perpendiculaire à la première zone 22, la deuxième portion inclinée 16 fait un angle de 15° par rapport à la portion de sommet 12. Ainsi, lorsque le module d'alimentation 2 est incliné de 15° pendant les tests de résistance aux fortes pluies, l'angle d'inclinaison de la deuxième portion inclinée 16 permet de protéger l'écoulement direct du liquide au niveau de ladite deuxième zone 24 du module 2, même pour la plus forte inclinaison.

Cependant, il est en outre avantageux de protéger le boîtier 20, en particulier la deuxième zone 24, et donc l'interface de branchement 240 du ruissellement indirect. En effet, si du liquide s'accumule à une extrémité libre de la deuxième portion inclinée 16, celui-ci aura tendance à ruisseler en-dessous de ladite portion inclinée 16 au lieu de s'évacuer en se détachant de ladite portion 16. Ce phénomène sera d'autant plus marqué si la deuxième portion inclinée 16 est plane, comme illustré à la figure 2.

Avantageusement, le dispositif de protection 1 peut alors comprendre un organe de retenue 18 ici en forme de L et/ou s'étendant perpendiculairement à partir de la deuxième portion inclinée 16.

L'organe de retenue 18 se présente globalement comme une gouttière située en bordure de la deuxième portion inclinée 16. Ledit organe de retenue 18 permet avantageusement d'empêcher le ruissellement indirect de liquide en-dessous de ladite deuxième portion inclinée 16 et le guide au contraire vers le côté, loin de l'interface de branchement 240, voire même loin des câbles 26.

La deuxième portion inclinée 16 peut en outre comprendre une languette distale 162 s'étend au-delà de l'organe de retenue 18. La languette 162 fournie une protection complémentaire de la deuxième zone 24 en la protégeant du ruissellement indirect de liquide subséquemment à un passage du module d'alimentation 2 d'une position inclinée à +/-15° à une position non inclinée. Elle remplit notamment un rôle de brise-goutte.

Préférentiellement, ladite plaque déflectrice 10 comprend un flanc d'accostage 100 au bloc de climatisation 3. Ledit flanc d'accostage 100 s'étend ici le long de la plaque déflectrice 10 perpendiculairement à des bordures latérales des portions de sommet 12 et inclinées 14, 16. Préférentiellement, également, ledit flanc d'accostage 100 est au moins en partie en appui contre le bloc de climatisation 3 et/ou suit au moins en partie les contours du bloc de climatisation 3.

Préférentiellement, la plaque déflectrice 10 comprend, en outre, un flanc incliné 110 s'étendant depuis les portions de sommet 12 et inclinées 14, 16. Ici, ledit flanc incliné 110 est situé le long de bordures des portions de sommet 12 et inclinées 14 et 16 opposées à celles depuis lesquelles s'étend le flanc d'accostage 100. À l'instar des portions inclinées 14, 16, le flanc incliné 110 permet d'entraîner l'écoulement du liquide au-delà des première et deuxième zones 22, 24 du boîtier 20 en fonction de l'angle d'inclinaison du module d'alimentation 2, selon un plan d'inclinaison orthogonal au premier plan.

La plaque 10 peut également comprendre des cloisons de renfort 102 s'étendant ici de manière perpendiculaire, à la portion de sommet 12 et/ou auxdites première et deuxième portions inclinées 14, 16. Préférentiellement, les cloisons de renfort 102 s'étendent depuis le flanc d'accostage 100 de sorte à obtenir un effet d'équerrage et délimiter des cavités au sein de la plaque déflectrice 10. Les cavités ainsi créées permettent de guider l'écoulement du liquide sur la plaque déflectrice 10. Cela permet en outre d'accumuler et de confiner un certain volume de liquide dans une ou plusieurs des cavités, jusqu'à ce que ledit volume de liquide soit entraîné au-delà du module d'alimentation 2 par le biais les portions inclinées 14, 16 et/ou le flanc incliné 110.

En outre, le dispositif de protection 1 peut être muni d'un moyen de fixation 101 au bloc de climatisation 3. De préférence, ledit moyen de fixation 101 peut être situé sur le flanc d'accostage 100 au bloc de climatisation 3. À titre d'exemple, le moyen de fixation 101 peut être un pion muni d'un orifice de passage pour un organe de fixation telle qu'une vis ou autre.

En référence à la figure 3, l'ensemble du module d'alimentation 2 et du dispositif de protection 1 dudit module est agencé selon la deuxième configuration.

Dans cette configuration, le dispositif de protection 1 est fixé, par exemple, au niveau du(es) câble(s) 26 électriques d'alimentation du module d'alimentation 2. Le dispositif de protection 1 peut de la sorte ne pas être fixé au bloc de climatisation 3.

Dans le cas d'espèce, la plaque déflectrice 10 comprend un orifice 104 de passage pour les câbles 26 électriques d'alimentation du module d'alimentation 2. Le diamètre de l'orifice 104 est ajusté à la largeur du(es) câble(s) 26 de sorte qu'il y ait peu ou pas de jeu lorsque le(s) câble(s) est(sont) dans l'orifice 104, c'est-à-dire que le dispositif de protection 1 soit lié de façon fixe auxdits câbles 26.

À cet effet, il peut en outre être prévu un joint d'étanchéité 106 au niveau de l'orifice 104. Le joint 106 est annulaire et agencé de manière à se conformer de façon étanche au(x) diamètre(s) de(s) câble(s) 26 et à la plaque 10. De préférence, le joint annulaire 106 est fait d'un matériau plastique. Cela permet, avantageusement, d'éviter le ruissellement du liquide entre la plaque déflectrice 10 et l'orifice 104. Cela permet, en outre, de faciliter le positionnement du dispositif de protection 1 au niveau des câbles 26.

Préférentiellement, l'orifice 104 peut être situé au niveau de la portion de sommet 12 de sorte que ladite portion de sommet 12 est située au moins en partie en vis-à-vis de l'interface de branchement 240. Concomitamment, les portions inclinées 14, 16 s'étendent au-delà des bordures de grandes faces 212, 214 du module d'alimentation 2.

Un tel agencement permet d'entraîner l'écoulement du liquide au-delà desdites première et deuxième zones 22, 24 du module d'alimentation 2, notamment lorsque ledit module d'alimentation 2 est incliné de +/- 15° dans différents plans.

Ladite plaque déflectrice 10 est faite, par exemple, d'un seul tenant, notamment par moulage.

De manière très avantageuse, en plus de la protection du module d'alimentation 2 par le dispositif 1, ladite carte de circuit imprimé peut être revêtue d'une couche 300 faite d'un matériau hydrophobe. Plus précisément, la carte de circuit imprimé peut comprendre des zones revêtues de la couche 300 faite d'un matériau hydrophobe et des interfaces de connexion non revêtues de ladite couche 300.

La couche 300 faite d'un matériau hydrophobe permet d'éviter que du liquide ne reste en contact avec la surface du module d'alimentation 2, et étanchéifie ainsi ledit module. Ainsi, quand bien même quelques gouttes de liquide parviendraient à atteindre le module d'alimentation 2, il ne serait pas possible que lesdites gouttes puissent pénétrer à l'intérieur dudit module, notamment au niveau desdites zones 22, 24.

## Revendications

1. Ensemble d'un module d'alimentation électrique (2) et d'un dispositif de protection (1) dudit module, ledit ensemble étant destiné à équiper un bloc de climatisation (3), notamment pour véhicule automobile, ledit module d'alimentation comprenant un boîtier (20) muni de zones permettant une pénétration de liquide à l'intérieur du boîtier (20), le dispositif de protection (1) s'étendant au moins en partie en vis-à-vis desdites zones de manière à entraîner un écoulement du liquide au-delà desdites zones, en fonction de l'orientation dudit module d'alimentation, **caractérisé en ce que** le dispositif de protection (1) comprend une plaque déflectrice (10) comprenant une première concavité et une deuxième concavité, et **en ce que** le module d'alimentation électrique (2) comprend une première zone (22) comportant une ligne de jonction (220) entre deux pièces (200, 202) du boîtier, et une deuxième zone (24) de branchement à des connecteurs externes, ladite plaque déflectrice (10) s'étendant en vis-à-vis desdites première et deuxième zones.

2. Ensemble selon la revendication 1, dans lequel la plaque déflectrice (10) comprend une portion de sommet (12), une première portion inclinée (14) et une deuxième portion inclinée (16).

3. Ensemble selon la revendication 2, dans lequel les portions inclinées (14, 16) et/ou la portion de sommet (12) sont planes.

4. Ensemble selon l'une des revendications 2 ou 3, dans lequel lesdites portions inclinées (14, 16) sont reliées à la portion de sommet (12) par des coudes (140, 160).

5. Ensemble selon l'une quelconque des revendications 2 à 4, dans lequel la deuxième portion inclinée (16) comprend un organe de retenue (18) s'étendant à partir de ladite deuxième portion inclinée (16) pour favoriser l'écoulement du liquide dans une direction donnée.

6. Ensemble selon l'une quelconque des revendications 2 à 5, dans lequel la plaque déflectrice (10) comprend un flanc d'accostage (100) au bloc de climatisation.

7. Ensemble selon l'une quelconque des revendications 2 à 6, dans lequel la plaque déflectrice (10) comprend un flanc incliné (110), lesdits flancs d'accostage (100) et incliné (110) étant situés au niveau des côtés opposés de la portion de sommet (12).

8. Ensemble selon l'une quelconque des revendications 2 à 7, dans lequel la plaque (10) comprend des cloisons de renfort (102) s'étendant à partir de la portion de sommet (12) et/ou desdites première et/ou deuxième portions inclinées (14, 16).

9. Ensemble selon l'une quelconque des revendications 1 à 8, dans lequel le dispositif de protection (1) comprend un moyen de fixation au bloc de climatisation (3).

10. Ensemble selon l'une quelconque des revendications 1 à 9, dans lequel la plaque déflectrice (10) comprend un orifice (104) de passage pour un ou plusieurs câbles électriques d'alimentation du module d'alimentation (2).

11. Ensemble selon l'une quelconque des revendications précédentes, dans lequel le module d'alimentation électrique (2) comprend une carte de circuit imprimé, ladite carte de circuit imprimé étant revêtue d'une couche (300) faite d'un matériau hydrophobe.

12. Bloc de climatisation (3) pour véhicule automobile équipé d'un ensemble selon l'une quelconque des revendications précédentes.

13. Bloc selon la revendication 12 comprenant un dispositif de chauffage électrique muni dudit module d'alimentation électrique (2).

## Patentansprüche

1. Einheit aus einem Stromversorgungsmodul (2) und einer Schutzvorrichtung (1) für das Modul, wobei die Einheit zur Ausstattung einer Klimaanlage (3), insbesondere für ein Kraftfahrzeug, bestimmt ist, wobei das Versorgungsmodul ein Gehäuse (20) umfasst, das mit Bereichen versehen ist, die ein Eindringen von Flüssigkeit in das Innere des Gehäuses (20) erlauben, wobei sich die Schutzvorrichtung (1) zumindest teilweise gegenüber den Bereichen erstreckt, so dass sie in Abhängigkeit von der Ausrichtung des Versorgungsmoduls ein Abfließen der Flüssigkeit über die Bereiche hinaus bewirkt,
**dadurch gekennzeichnet, dass** die Schutzvorrichtung (1) eine Ablenkplatte (10) mit einer ersten Konkavität und einer zweiten Konkavität umfasst und dass das Stromversorgungsmodul (2) einen ersten Bereich (22) mit einer Verbindungsleitung (220) zwischen zwei Teilen (200, 202) des Gehäuses und einen zweiten Bereich (24) zum Anschluss an externe Verbinder umfasst, wobei sich die Ablenkplatte (10) gegenüber dem ersten und zweiten Bereich erstreckt.

2. Einheit nach Anspruch 1, wobei die Ablenkplatte (10) einen Scheitelabschnitt (12), einen ersten geneigten Abschnitt (14) und einen zweiten geneigten Abschnitt (16) umfasst.

3. Einheit nach Anspruch 2, wobei die geneigten Abschnitte (14, 16) und/oder der Scheitelabschnitt (12) eben sind.

4. Einheit nach einem der Abschnitte 2 oder 3, wobei die geneigten Abschnitte (14, 16) durch Bögen (140, 160) mit dem Scheitelabschnitt (12) verbunden sind.

5. Einheit nach einem der Ansprüche 2 bis 4, wobei der zweite geneigte Abschnitt (16) ein Rückhalteelement (18) umfasst, das sich vom zweiten geneigten Abschnitt (16) erstreckt, um das Ablaufen der Flüssigkeit in einer gegebenen Richtung zu begünstigen.

6. Einheit nach einem der Ansprüche 2 bis 5, wobei die Ablenkplatte (10) eine Flanke (100) zum Andocken an die Klimaanlage umfasst.

7. Einheit nach einem der Ansprüche 2 bis 6, wobei die Ablenkplatte (10) eine geneigte Flanke (110) umfasst, wobei die Andockflanke (100) und die geneigte Flanke (110) auf gegenüberliegenden Seiten des Scheitelabschnitts (12) angeordnet sind.

8. Einheit nach einem der Ansprüche 2 bis 7, wobei die Platte (10) verstärkende Trennwände (102) umfasst, die sich von dem Scheitelabschnitt (12) und/oder dem ersten und/oder dem zweiten geneigten Abschnitt (14, 16) erstrecken.

9. Einheit nach einem der Ansprüche 1 bis 8, wobei die Schutzvorrichtung (1) ein Mittel zur Befestigung an der Klimaanlage (3) umfasst.

10. Einheit nach einem der Ansprüche 1 bis 9, wobei die Ablenkplatte (10) eine Durchgangsöffnung (104) für ein oder mehrere elektrische Kabel zur Versorgung des Versorgungsmoduls (2) umfasst.

11. Einheit nach einem der vorangehenden Ansprüche, wobei das Stromversorgungsmodul (2) eine Leiterplatte umfasst, wobei die Leiterplatte mit einer Schicht (300) beschichtet ist, die aus einem hydrophoben Material gefertigt ist.

12. Klimaanlage (3) für ein Kraftfahrzeug, das mit einer Einheit nach einem der vorangehenden Ansprüche ausgestattet ist.

13. Anlage nach Anspruch 12, umfassend eine elektrische Heizvorrichtung, die mit dem Stromversorgungsmodul (2) ausgestattet ist.

## Claims

1. Assembly of an electric power supply module (2) and of a protective device (1) for said module, said assembly being intended to equip an air-conditioning unit (3), in particular for a motor vehicle, said power supply module comprising a housing (20) provided with regions allowing penetration of liquid into the housing (20), the protective device (1) extending at least partially facing said regions so as to cause the liquid to flow beyond said regions, depending on the orientation of said power supply module, **characterized in that** the protective device (1) comprises a deflecting plate (10) comprising a first concavity and a second concavity, and **in that** the electric power supply module (2) comprises a first region (22) having a joining line (220) between two parts (200, 202) of the housing, and a second region (24) for connection to external connectors, said deflecting plate (10) extending facing said first and second regions.

2. Assembly according to Claim 1, wherein the deflecting plate (10) comprises a top portion (12), a first inclined portion (14) and a second inclined portion (16) .

3. Assembly according to Claim 2, wherein the inclined portions (14, 16) and/or the top portion (12) are flat.

4. Assembly according to either of Claims 2 and 3, wherein said inclined portions (14, 16) are connected to the top portion (12) by elbows (140, 160).

5. Assembly according to any one of Claims 2 to 4, wherein the second inclined portion (16) comprises a retaining member (18) extending from said second inclined portion (16) so as to promote the flow of the liquid in a given direction.

6. Assembly according to any one of Claims 2 to 5, wherein the deflecting plate (10) comprises a flank (100) for mating with the air-conditioning unit.

7. Assembly according to any one of Claims 2 to 6, wherein the deflecting plate (10) comprises an inclined flank (110), said mating flank (100) and inclined flank (110) being situated on opposite sides of the top portion (12) .

8. Assembly according to any one of Claims 2 to 7, wherein the plate (10) comprises reinforcing partitions (102) extending from the top portion (12) and/or said first and/or second inclined portions (14, 16).

9. Assembly according to any one of Claims 1 to 8, wherein the protective device (1) comprises a means for fastening to the air-conditioning unit (3).

10. Assembly according to any one of Claims 1 to 9, wherein the deflecting plate (10) comprises an orifice (104) for the passage of one or more electrical power supply cables of the power supply module (2).

11. Assembly according to any one of the preceding claims, wherein the electric power supply module (2) comprises a printed circuit board, said printed circuit board being coated with a layer (300) made of a hydrophobic material.

12. Air-conditioning unit (3) for a motor vehicle, equipped with an assembly according to any one of the preceding claims.

13. Unit according to Claim 12, comprising an electric heating device provided with said electric power supply module (2).
